# EUROPEAN PATENT SPECIFICATION

(11) **EP 2 103 199 B1**
(45) Date of publication and mention of the grant of the patent: **26.05.2010**
(21) Application number: 07701072.6
(22) Date of filing: 08.01.2007
(51) Int. Cl.: H05K 5/00, H05K 5/04

(54) **A METHOD OF ASSEMBLING A MULTI-CHAMBER ELECTRONIC ENCLOSURE**
VERFAHREN ZUM ZUSAMMENBAU EINES ELEKTRONISCHEN GEHÄUSES MIT MEHREREN KAMMERN
PROCEDE D'ASSEMBLAGE D'UNE ENCEINTE ELECTRONIQUE A MULTIPLES CHAMBRES

(43) Date of publication of application: 23.09.2009
(73) Proprietor: Terra Uab, 51256 Kaunas (LT)
(72) Inventor: MALDZIUNAS, Gintautas, 50143 Kaunas (LT); SKOROBOGATOV, Genadij, 46408 Kaunas (LT); SKIPARIS, Linas, 51477 Kaunas (LT)
(74) Representative: Zaboliene, Reda
(86) International application number: PCT/LT2007/000002
(87) International publication number: WO 2008/085016

(56) References cited:
- EP-A- 0 448 545
- EP-A2- 0 844 813
- DE-U1- 29 806 777
- US-A- 4 090 632
- US-A- 6 108 194
- US-B1- 6 359 218
- US-B1- 6 541 699

## Description

### FIELD OF THE INVENTION

The present invention is related to enclosures for housing radio frequency electronic circuit boards and particularly to multi-chamber electronic enclosures for housing cable, satellite and terrestrial TV equipment boards. An aluminium connecting profile is used for assembling the enclosure containing at least two chambers.

### BACKGROUND OF THE INVENTION

There are several known methods for assembling of metal enclosures for use in the field of radio frequency electronics. In one method, the edges of metal plates are treated so that it is possible to form an enclosed metal case from these plates by hooking together the plate edges or joining them by means of bolts. Another method involves joining together metal plates by means of connecting profiles to form a metal enclosure.

Such enclosures exhibit appropriate shielding properties and are destined for the shielding of electronic circuit boards, which are housed inside the enclosure, from the influence of external electromagnetic fields. The shielding also prevents the transmission of electromagnetic high-frequency signals, produced by the interior electronic devices within the enclosure, to the air-space outside the enclosure. The presence of unwanted interferences from electromagnetic waves and the noise level of the electronic circuit boards inside of the enclosure, depend on the shielding factor (measured in dB) of the enclosure. This defines the ratio of the electromagnetic field outside to the remaining field inside the shielding enclosure.

We can improve the shielding properties of the enclosure only by either removing or reducing as much as possible the gaps between the constituent parts of the metal enclosure.

U.S. Patent No. US 6,359,218 B1 published on Mar. 19, 2002 is known. According to this patent, a modular enclosure for electronic circuits of selectable height is achieved via the use of intermediate stackable frame members. The top and bottom of the enclosure are closed with metal lids. All the components are fixed together by fasteners, such as screws or bolts. The disadvantages of this solution are the complicated process of assembling the enclosure and the small range of possible sizes. Only the height of the enclosure is easily adjustable. If a metal enclosure of a different width or length is required, different stamping machines moulds must be made. That is why this process may be rather expensive. Enclosures of this design do not allow for the dividing the enclosure with metal partitions. Therefore it is impossible to subdivide the enclosure into separate chambers, which would need to be shielded from each other.

Another important patent is U.S. Patent No. 6,002,086 published on Dec. 14, 1999. According to this patent, the metal structure is assembled from a variety of shield casings and shield covers which are interposed between the shield casings. The disadvantages of this solution are high production costs and poor shielding properties. During the manufacturing process of the partition walls cut-outs are made, which results in a considerable amount of left-over sheet-metal being discarded. Once such a construction is assembled, small gaps between the sheet-metal frames and the partition walls remain, which significantly diminishes the shielding properties of the enclosure.

European Patent Application No. 91870049.3 filed on Mar. 20, 1991 is relevant here. It describes a construction which is comprised of special rectangular frames with lengthwise slots coupled together by means of coupling pieces. Such frames can be coupled together and form chambers of several sizes, whose sides are covered by means of special panels. Such enclosures have acceptable shielding properties; however manufacturing its components involves numerous complex processes. Another disadvantage of this solution is the fixed size of the frames, which renders the construction unwieldy and difficult to apply in cases of individual enclosures where electronic equipment of different sizes must be packed as compactly as possible.

The known U.S. Patent No. US 6,541,699 B1 published on Apr. 01, 2003 describes an improved electromagnetic interference connection between a pair of electromagnetic interference enclosures. This connection comprises a detachable lap joint integrally constructed along the first pair of edges in the first electromagnetic interference enclosure, and a second pair of edges in the second electromagnetic interference enclosure. When metal enclosures are joined in this way, electronic components housed inside are shielded effectively. Additionally, further seals or fasteners are not needed for joining the enclosures. Using this method, more enclosures can be joined together whilst the construction remains simple and compact. The disadvantage of this solution is the complex designing process of such enclosures and the relatively time-consuming process of preparing the edges. Also, expensive precision equipment is required to bend grooves of small dimensions.

### SUMMARY OF THE INVENTION

This invention is aimed at devising a cheap method of assembling a multi-chamber electronic enclosure for use in the field of radio frequency electronics. The method allows fast and simple assembly of multi-chamber constructions of various dimensions with appropriate radio frequency shielding properties.

Based on such criteria, a method of assembling the multi-chamber electronic enclosure has been developed. It comprises the use of an aluminium connecting profile (1) for connecting sheet-metal frames (2) and partition walls (3) to an enclosed case and for joining the enclosures together. The profile has at least two grooves (4) having rectangular- or square-shaped cross-section, which are positioned at 90° or 180° angles (7) to each other. The rectangular metal partition-plates (3) and the sheet-metal frames (2) are fitted into the grooves (4). At least one continuous projection (5) located in the inner wall (6) of the groove (4) abuts against the metal plate equally along the entire profile length. In this way, gaps are eliminated and good shielding properties of the enclosure are ensured.

### BRIEF DESCRIPTION OF THE DRAWINGS

Fig. 1 The construction of the multi-chamber electronic enclosure.
Fig.2 The connecting profile and the shape of its cross-section.
Fig.3 The connection of the metal plate and the connecting profile.
Fig.4 The preferred embodiment of the enclosure assembly when the ends (8) of the aluminium profile are cut off at a 90° angle.
Fig.5 The preferred embodiment of the enclosure assembly when the ends (8) of the aluminium profile are cut off at a 45° angle.

### DESCRIPTION OF THE PREFERRED EMBODIMENT

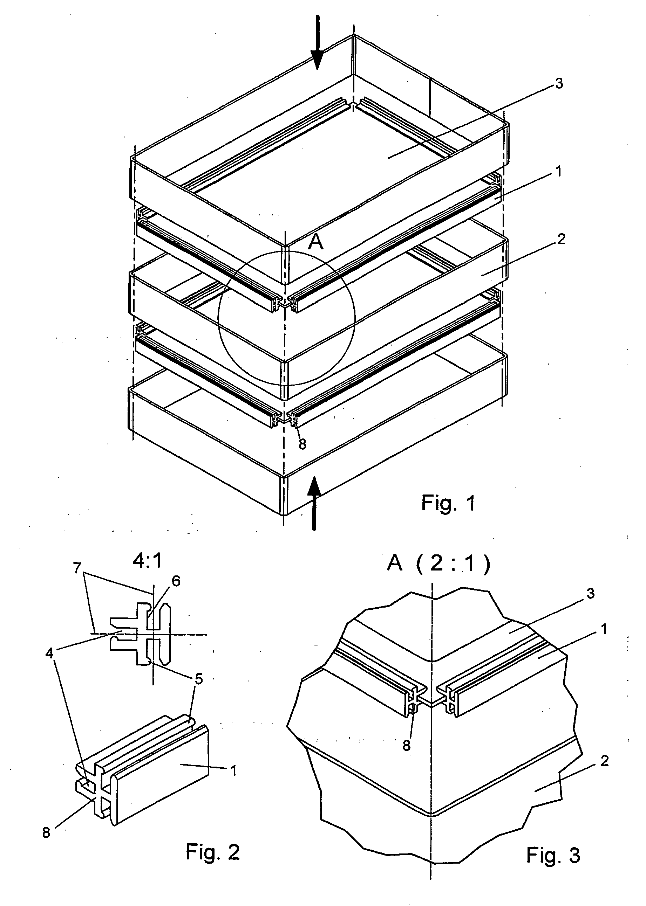

The most appropriate embodiment of implementing the present invention is the assembling of the multi-chamber electronic enclosure as illustrated in Fig. 1. The construction is assembled from the sheet-metal frames (2), connecting profiles (1) and sheet-metal partition plates (3). The components are joined together to form a multi-chamber enclosure for the purpose of providing the housing for electronic circuit boards in the appropriate chambers. Individual chambers can be easily opened without disassembling and damaging the entire construction of the enclosure.

The electronic circuit boards housed within each chamber are shielded from the influence of external electromagnetic fields.

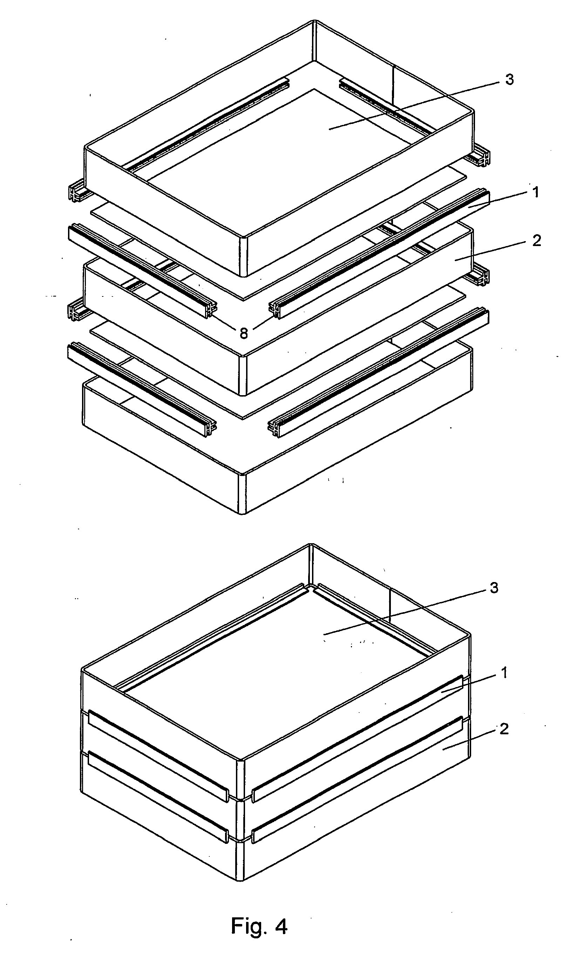

Fig. 1 and Fig. 4 illustrate the preferred embodiment of assembling the multi-chamber electronic enclosure when the ends (8) of the connecting profiles (1) are cut off at a 90° angle. This is a very fast and simple method to assemble the enclosure. However, due to the gaps, which remain in the corners, such way an approach results in lower shielding properties.

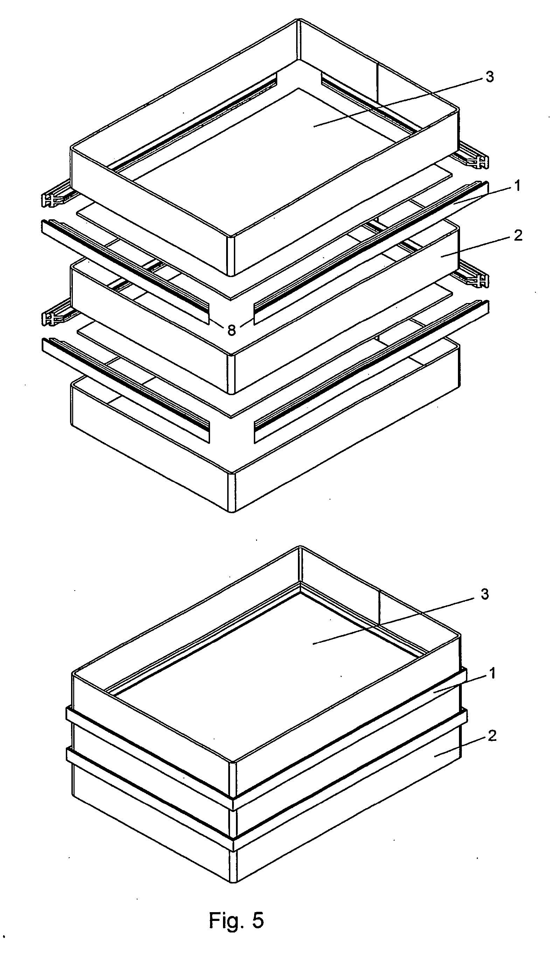

Fig. 5 illustrates the preferred embodiment of assembling the multi-chamber electronic enclosure when the ends (8) of the connecting profiles (1) are cut off at a 45° angle. Such method of joining enclosure elements requires more time because the side lengths of the partition plate (3) must be measured precisely before cutting off the profile (1). Any gaps in the corners of such enclosure are practically eliminated; therefore the enclosure of such construction exhibits fairly good shielding properties.

A continuous projection (5) is present in the inner wall (6) of the groove (4) of the connecting profile (1) lengthwise to the profile (1). When the sheet-metal partition plate (3) or the frame (2) is fitted in the groove (4), the continuous projection (5) located in the inner wall (6) of the groove (4) abuts against the sheet-metal partition plate (3) or the frame (2) along the entire length of the profile. Such joining of the connecting profile (1) and the sheet-metal frame (2) or the partition plate (3) allows arranging the enclosure components into an enclosed metal shield.

It is recommended to manufacture the connecting profile (1) from aluminium, although other materials with similar shielding properties can also be used. The wire drawing method used in manufacturing the connecting profile (1) involves drawing a rectangular aluminium rod through a hole, which has the shape of the profile (1) cross-section. This manufacturing process is fast and cheap. It also allows the manufacturing of a connecting profile (1) of relatively small dimensions. Compactness is an important property in electronics; therefore a connecting profile (1) of small dimensions is very well applicable here. It is recommended to manufacture the enclosure walls and the partition plates from sheet-metal of a thickness which will ensure firm fitting through the projections (5) into the groove (4).

## Claims

1. A method of assembling a multi-chamber electronic enclosure for use in the field of radio frequency electronics, especially for housing cable, satellite and terrestrial TV equipment boards, comprising a connection means for connecting the metal constituent parts of the above mentioned enclosure, such as sheet-metal frames (2) and metal partition walls (3), **characterized by** a metal connecting profile (1) used for joining the sheet-metal frames (2) and the metal partition walls (3) together, possessing inside of at least two grooves (4) with rectangular- or square-shaped cross-section, which are arranged in such a way that they are used to fit the thin metal partition walls (3) and the sheet-metal frames (2) into position; where the said metal connecting profile (1) forms the edges of each chamber of the enclosure and at the same time is used to connect metal partition walls (3) together to the sheet-metal frames (2) of the upper and/or lower chambers respectively and are cut off at the desired length in accordance to the dimensions of the chamber to form a solid binding along the entire perimeter of each chamber of the enclosure in order to ensure more effective electromagnetic shielding continuity between the metal constituent parts of the above mentioned electronic enclosure.

2. The method of assembling according to the claim 1, **characterized by** the grooves (4) being positioned at a 90° or 180° angle to each other.

3. The method of assembling according to one of the claims 1 or 2, **characterized by** at least one continuous projection (5) being arranged in the inner wall (6) of each groove (4) of the connecting profile (1); where the said projection abuts against either the fitted partition plate (3) or the frame (2) uniformly along the entire profile length.

4. The assembling method according to the claims 1 and 2, **characterized by** the ends of the connecting profiles being cut off at a 90° angle.

5. The assembling method according to the claims 1 and 2, **characterized by** the ends of the connecting profiles being cut off at a 45° angle.

6. The assembling method according to any of the claims 1 to 5, **characterized by** the connecting profile (1) being made from aluminium.

## Patentansprüche

1. Verfahren zum Zusammenbau eines elektronischen Mehrkammergehäuses zum Einsatz im Bereich der Radiofrequenzelektronik, vor allem für das Unterbringen von Geräteplatinen für Kabel-, Satelliten- und Antennenfernsehen, bestehend aus einer Verbindung für die Metallbestandteile des oben genannten Gehäuses, darunter den Rahmen aus Metallblech (2) und die Trennwände aus Metall (3), **gekennzeichnet durch** ein Verbindungsprofil aus Metall (1), das für die Verbindung des Rahmens aus Metallblech (2) mit den Trennwänden aus Metall (3) verwendet wird, das innen mindestens zwei Nuten (4) mit rechteckigem oder quadratischem Profil hat. Diese sind so angeordnet, dass sie die dünnen Trennwänden (3) und die Rahmen aus Metallblech (2) an ihrem Platz halten; wobei das genannte Metallprofil (1) die Ecke einer Gehäusekammer bildet und gleichzeitig dazu dient, die Metalltrennwände (3) mit den Rahmen aus Metallblech (2) der jeweiligen oberen und/oder unteren Kammern zu verbinden und in der gewünschten Länge den Maßen des Gehäuses entsprechend abgeschnitten wird, damit eine stabile Verbindung entlang des gesamten Umfangs jeder Gehäusekammer entsteht, um eine effektivere elektromagnetische Abschirmung zwischen den Metallbestandteilen des oben genannten Elektronikgehäuses zu gewährleisten.

2. Verfahren zum Zusammenbau gemäß Anspruch 1, **gekennzeichnet durch** Nuten (4), die in einem Winkel von 90° oder 180° zueinander positioniert werden.

3. Verfahren zum Zusammenbau gemäß einem der Ansprüche 1 oder 2, **gekennzeichnet durch** mindestens einen durchgehenden Überhang (5) an der inneren Wand (6) von jeder Nut (4) des Verbindungsprofls (1); wobei der genannte Überhang gleichmäßig auf der gesamten Länge des Profils entweder auf die eingepasste Trennplatte (3) oder den Rahmen (2) trifft.

4. Verfahren zum Zusammenbau gemäß den Ansprüchen 1 und 2, **gekennzeichnet dadurch, dass** die Enden der Verbindungsprofile in einem Winkel von 90° abgeschnitten werden.

5. Verfahren zum Zusammenbau gemäß den Ansprüchen 1 und 2, **gekennzeichnet dadurch, dass** die Enden der Verbindungsprofile in einem Winkel von 45° abgeschnitten werden.

6. Verfahren zum Zusammenbau gemäß einem der Ansprüche 1 bis 5, **gekennzeichnet dadurch, dass** das Verbindungsprofil (1) aus Aluminium hergestellt wird.

## Revendications

1. Procédé d'assemblage d'une enceinte électronique multi-chambres à utiliser dans le domaine de l'électronique radiofréquence, notamment pour recevoir un équipement de TV par câble, satellite et terrestre, comprenant un moyen de connexion servant à connecter les constituants en métal de l'enceinte susmentionnée, comme les cadres en tôle (2) et les parois de séparation (3), **caractérisé par** un profil métallique de connexion (1) utilisé pour joindre les cadres en tôle (2) et les parois de séparation (3) les uns aux autres, avec à l'intérieur au moins deux rainures (4) présentant des coupes transversales rectangulaires ou carrées qui sont réalisées de façon à ce que puissent y être ajustées les fines parois de séparation (3) et les cadres en tôle (2), où ledit profil métallique de connexion (1) suit le bord de chacune des chambres de l'enceinte et est utilisé en même temps pour connecter les parois de séparation (3) avec les cadres en tôle (2) des chambres hautes et/ou basses respectivement et peut être découpé à la longueur désirée conformément aux dimensions de la chambre afin de former une fixation solide le long du périmètre entier de chaque chambre de l'enceinte pour assurer une conduction électromagnétique plus efficace entre les constituants métalliques de l'enceinte électronique susmentionnée.

2. Procédé d'assemblage selon la revendication 1, **caractérisé par** des rainures (4) positionnées à un angle de 90° ou 180° les unes des autres.

3. Procédé d'assemblage selon l'une des revendications 1 ou 2, **caractérisé par** au moins une projection continue (5) réalisée dans la paroi interne (6) de chaque rainure (4) du profil de connexion (1), où ladite projection est contiguë soit à la plaque en tôle encastrée (3) soit au cadre (2) de façon uniforme sur l'entière longueur du profilé.

4. Procédé d'assemblage selon les revendications 1 et 2, **caractérisé par** les extrémités des profilés connecteurs découpées à un angle de 90°.

5. Procédé d'assemblage selon les revendications 1 et 2, **caractérisé par** les extrémités des profilés connecteurs découpées à un angle de 45°.

6. Procédé d'assemblage selon l'une quelconque des revendications 1 à 5, **caractérisé par** le profil de connexion (1) réalisé en aluminium.
